## Europäisches Patentamt
## European Patent Office
## Office européen des brevets

(19)

(11) Veröffentlichungsnummer: **0 033 882**
**B1**

(12)

# EUROPÄISCHE PATENTSCHRIFT

(45) Veröffentlichungstag der Patentschrift:
04.09.85

(51) Int. Cl.⁴: **G 03 C 1/76**

(21) Anmeldenummer: **81100533.9**

(22) Anmeldetag: **25.01.81**

(54) Verfahren zur Herstellung eines optisch aktiven Flächengebildes.

(30) Priorität: **25.01.80 CH 588/80**

(43) Veröffentlichungstag der Anmeldung:
**19.08.81 Patentblatt 81/33**

(45) Bekanntmachung des Hinweises auf die Patenterteilung:
**04.09.85 Patentblatt 85/36**

(84) Benannte Vertragsstaaten:
**AT BE DE FR GB IT NL SE**

(56) Entgegenhaltungen:
**DE - A - 1 623 803**
**DE - A - 1 798 372**
**DE - A - 2 409 702**
**DE - B - 1 003 582**
**FR - A - 1 510 813**
**FR - A - 2 228 630**
**FR - A - 2 256 423**
**GB - A - 9 929**
**GB - A - 1 280 625**
**US - A - 3 269 839**
**US - A - 3 584 369**
**US - A - 4 175 844**

(73) Patentinhaber: **Demolux GmbH & Co.KG.,**
**Wiesenstrasse 3-5, D-6070 Langen (DE)**

(72) Erfinder: **Petraglio, Hortense, Holzgasse 11,**
**CH-2575 Gerolfingen (CH)**

(74) Vertreter: **Junius, Walther, Dr., Wolfstrasse 24,**
**D-3000 Hannover 81 (DE)**

**Beschreibung**

Die Erfindung betrifft ein Verfahren zur Herstellung eines optisch aktiven Flächengebildes, welches auf eine diffus reflektierende Fläche fallendes Licht in einer Richtung senkrecht zu dieser Fläche bündelt.

Derartige optisch aktive Flächengebilde werden bei der Projektion von Bildern mit einem optischen Projektor angewandt (US-A-3 269 839, US-A-4 175 844 u.a.). Nachteil der bisher bekannten optisch aktiven Flächengebilde dieser Art ist es, dass ihr Auflösevermögen äusserst schlecht ist, so dass ihre Anwendung auf wenige Fälle beschränkt blieb, bei denen nur sehr grobe Muster abzubilden waren.

Es sind verschiedene Verfahren zur Herstellung von Farblinienrastern, z.B. für die additive Farbenphotographie (DE-A-1 1 003 582), aber auch für die Spektrographie (DE-A-1 623 803) bekannt geworden, die durch Lösung oder Ätzung hergestellt werden. Hier sind es im wesentlichen drei Verfahren, die zur Anwendung kommen können: Ein Verfahren, bei dem auf einen durchsichtigen Träger mit einer photoempfindlichen Schicht, deren von Licht getroffene Teile eine andere Löslichkeit oder Ätzbarkeit als die nicht von Licht getroffene Teile aufweisen, ein Punkt- oder Linienraster optisch abgebildet wird, ein Verfahren, bei dem auf eine durchsichtige, aus löslichem oder ätzbarem Material bestehende Platte oder Folie ein Punkt- oder Linienraster aus einem die Lösung oder Ätzung verhindernden oder verzögernden Material aufgedruckt wird, und ein Verfahren, bei dem auf eine Metallplatte mit photoempfindlicher Schicht, deren von Licht getroffene Teile eine andere Ätzbarkeit als die nicht vom Licht getroffene Teile aufweisen, ein Punkt- oder Linienraster optisch abgebildet wird, wonach die Ätzung durchgeführt wird, wonach eine plastische Abbildung oder Abformung der Oberfläche der Metallplatte auf die Oberfläche einer durchsichtigen Folie oder Platte erfolgt.

Es ist die Aufgabe der vorliegenden Erfindung, mit einfachen Mitteln eine Möglichkeit zu schaffen, ein optisch aktives Flächengebilde herzustellen, welches mit grosser Auflösung das auf eine diffus reflektierende Fläche fallende Licht in einer Richtung senkrecht zu dieser Fläche bündelt.

Diese Aufgabe lässt sich auf dreierlei Weise lösen: Durch ein Verfahren zur Herstellung eines optisch aktiven Flächengebildes, bei dem auf einen durchsichtigen Träger mit einer photoempfindlichen Schicht, deren von Licht getroffene Teile eine andere Löslichkeit oder Ätzbarkeit als die nicht von Licht getroffene Teil aufweisen, ein Punkt- oder Linienraster optisch abgebildet wird, dass dadurch gekennzeichnet ist, dass ein Raster abgebildet wird, bei dem ein oder mehrere Rasterelemente pro Quadratmillimeter vorgesehen sind, und dass die Lösung oder Ätzung so lange durchgeführt wird, bis erhabene Zylinderteile oder Kugelteile in der photoempfindlichen Schicht oder im Träger sichtbar werden.

Durch ein Verfahren zur Herstellung eines optisch aktiven Flächengebildes, bei dem auf eine durchsichtige, aus löslichem oder ätzbarem Material bestehende Platte oder Folie ein Punkt- oder Linienraster aus einem die Lösung oder Ätzung verhindernden oder verzögernden Material aufgedruckt wird, das dadurch gekennzeichnet ist, dass ein Raster aufgedruckt wird, bei dem ein oder mehrere Rasterelemente pro Quadratmillimeter vorgesehen sind, und dass die Lösung oder Ätzung so lange durchgeführt wird, bis erhabene Zylinderteile oder Kugelteile in dem die Lösung oder Ätzung verhindernden oder verzögernden Material, in der Platte oder in der Folie sichtbar werden.

Durch ein Verfahren zur Herstellung eines optisch aktiven Flächengebildes, bei dem auf eine Metallplatte mit photoempfindlicher Schicht, deren von Licht getroffene Teile eine andere Ätzbarkeit als die nicht vom Licht getroffene Teile aufweisen, ein Punkt- oder Linienraster optisch abgebildet wird, wonach die Ätzung durchgeführt wird, wonach eine plastische Abbildung oder Abformung der Oberfläche der Metallplatte auf die Oberfläche einer durchsichtigen Folie oder Platte erfolgt, das dadurch gekennzeichnet ist, dass ein Raster abgebildet wird, bei dem ein oder mehrere Rasterelemente pro Quadratmillimeter vorgesehen sind, und dass die Ätzung so lange durchgeführt wird, bis die Oberfläche der Metallplatte für die Abformung erhabener Zylinderteile oder Kugelteile geeignet ist.

Wird ein derartiges Flächengebilde auf eine diffus reflektierende Vorlage gelegt, so wird auch seitlich auf die Vorlage fallendes Licht senkrecht zur Vorlage gebündelt reflektiert. Dadurch wird ein hoher Lichtstrom in Richtung senkrecht zur Oberfläche des Flächengebildes erzeugt. Die einzelnen Kugel- und/oder Zylinderteile weisen dabei Grössen auf, die an mikroskopische Grössen grenzen. Hierdurch wird eine hohe Auflösung erzielt.

Das Wesen der Erfindung ist nachstehend anhand von in der Zeichnung schematisch dargestellten Ausführungsbeispielen näher erläutert. Es zeigen:

Fig. 1 eine perspektivische Ansicht eines kleinen Teiles aus einem optisch aktiven Flächengebilde mit einem Punktraster.

Fig. 2 ein kleines Teil aus einem optisch aktiven Flächengebilde mit einem Linienraster.

Fig. 3 eine Ansicht eines kleines Teiles eines optisch aktiven Flächengebildes mit Punktraster in regelmässiger Anordnung.

Fig. 4 einen kleinen Ausschnitt aus der Ansicht eines optisch aktiven Flächengebildes mit Punktraster in unregelmässiger Anordnung.

Fig. 5 einen kleinen Ausschnitt aus einem optisch aktiven Flächengebilde mit Linienraster in regelmässiger Anordnung.

Fig. 6 einen kleinen Ausschnitt aus einer Ansicht eines optisch aktiven Flächengebildes mit Linienraster in unregelmässiger Anordnung.

Alle Zeichnungsfiguren sind in starker Vergrösserung dargestellt. Denn pro Quadratmillimeter sind mehrere Rasterelemente vorgesehen.

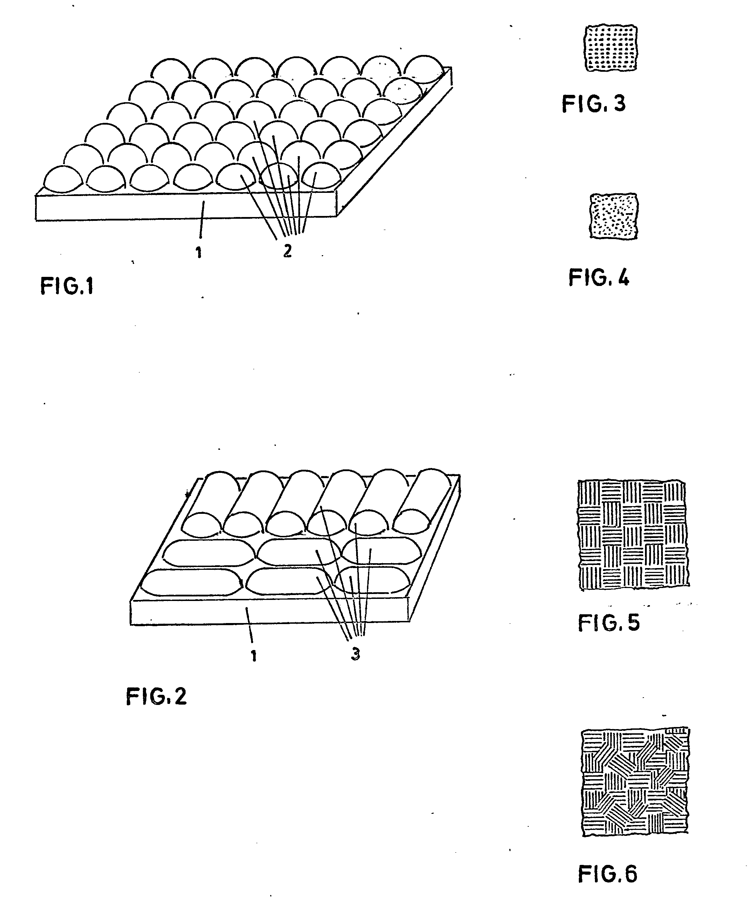

Im Ausführungsbeispiel der Fig. 1 ist die Oberfläche der Folie 1 mit Rasterelementen 2 versehen, die die Gestalt eines Teiles einer Kugel aufweisen und die regelmässig angeordnet sind.

Im Ausführungsbeispiel der Fig. 2 weist die Oberfläche der Folie 1 zylinderteilförmige Erhebungen in regelmässiger Rasteranordnung auf. Die perspektivischen Ansichten der Fig. 1 und 2 sind dabei sehr stark vergrössert.

Im Ausführungsbeispiel der Fig. 3 ist eine Ansicht von oben auf einen Punktraster von Kugelteilelementen auf der Oberfläche dargestellt. In Fig. 4 ist diese Anordnung unregelmässig.

In Fig. 5 ist eine Ansicht von oben auf ein Flächengebilde mit einem Raster von Zylinderteilen in regelmässiger Anordnung gezeigt, in Fig. 6 in unregelmässiger Anordnung.

Vorteile dieses optisch aktiven Flächengebildes sind:

Starke Bündelung des von einer unter dem Flächengebilde liegenden Vorlage diffus reflektierenden Lichtes in Richtung senkrecht zur Ebene der Fläche.

Leichte Herstellbarkeit nach aus der Drucktechnik bekannten Ätz- und Lösungsvorgängen.

Ausführbarkeit an den verschiedensten Materialien entweder durch direkte Lösung oder durch Abformung von einer geätzten Vorlage.

Herstellungsmöglichkeit in ebenen Platten.

Herstellungmöglichkeit in biegsamen Folien.

Anwendbarkeit in verschiedenen optischen Geräten.

Anwendbarkeit durch Aufkleben auf die diffus reflektierende Vorlage.

## Patentansprüche

1. Verfahren zur Herstellung eines optisch aktiven Flächengebildes, bei dem auf einen durchsichtigen Träger mit einer photoempfindlichen Schicht, deren von Licht getroffenen Teile eine andere Löslichkeit oder Ätzbarkeit als die nicht von Licht getroffenen Teile aufweisen, ein Punkt- oder Linienraster optisch abgebildet wird, dadurch gekennzeichnet, dass ein Raster abgebildet wird, bei dem ein oder mehrere Rasterelemente pro Quadratmillimeter vorgesehen sind, und dass die Lösung oder Ätzung so lange durchgeführt wird, bis erhabene Zylinderteile oder Kugelteile in der photoempfindlichen Schicht oder im Träger sichtbar werden.

2. Verfahren zur Herstellung eines optisch aktiven Flächengebildes, bei dem auf eine durchsichtige, aus löslichem oder ätzbarem Material bestehende Platte oder Folie ein Punkt- oder Linienraster aus einem die Lösung oder Ätzung verhindernden oder verzögernden Material aufgedruckt wird, dadurch gekennzeichnet, dass ein Raster aufgedruckt wird, bei dem ein oder mehrere Rasterelemente pro Quadratmillimeter vorgesehen sind, und dass die Lösung oder Ätzung so lange durchgeführt wird, bis erhabene Zylinderteile oder Kugelteile in dem die Lösung oder Ätzung verhindernden oder verzögernden Material in der Platte oder in der Folie sichtbar werden.

3. Verfahren zur Herstellung eines optisch aktiven Flächengebildes, bei dem auf eine Metallplatte mit photoempfindlicher Schicht, deren von Licht getroffene Teile eine andere Ätzbarkeit als die nicht vom Licht getroffenen Teile aufweisen, ein Punkt- oder Linienraster optisch abgebildet wird, wonach die Ätzung durchgeführt wird, wonach eine plastische Abbildung oder Abformung der Oberfläche der Metallplatte auf die Oberfläche einer durchsichtigen Folie oder Platte erfolgt, dadurch gekennzeichnet, dass ein Raster abgebildet wird, bei dem ein oder mehrere Rasterelemente pro Quadratmillimeter vorgesehen sind, und dass die Ätzung so lange durchgeführt wird, bis die Oberfläche der Metallplatte für die Abformung erhabener Zylinderteile oder Kugelteile geeignet ist.

## Claims

1. A process for the production of an optically active surface structure, in which a dot or line grid is optically represented on a transparent carrier having a photo-sensitive layer, those parts of which on which light is incident exhibiting a different solubility or etchability from those parts on which light is not incident, characterised in that a grid is represented in which one or more grid elements are provided per square millimeter; and that the dissolution or etching is continued until raised cylindrical or spherical elements become visible in the photo-sensitive layer, or in the carrier.

2. A process for the production of an optically active surface structure in which a dot or line grid of a material which prevents or delays solution or etching is printed onto a transparent plate or film of suluble or etchable material, characterised in that a grid is applied by printing in which one or more grid elements are provided per square millimeter; and that the dissolution or etching is continued until raised cylindrical or spherical elements in the material which prevents or delays dissolution or etching, become visible in the plate or film.

3. A process for the production of an optically active surface structure, in which a dot or line grid is optically represented on a metal plate having a photo-sensitive layer, those parts of which on which light is incident exhibiting a different etchability to those parts on which light is not incident, whereafter etching is effected, whereafter a plastic moulding of the surface of the metal plate is transferred to the surface of a transparent film or plate, characterised in that a grid is represented in which one or more grid elements are provided per square millimeter; and that the etching is continued until the surface of the metal plate is suitable for the moulding of raised cylindrical or spherical elements.

## Revendications

1. Procédé pour fabriquer une structure plane active du point de vue optique, selon lequel on forme optiquement l'image d'un réseau de points ou de lignes sur un support transparent muni d'une couche photosensible, dont les parties atteintes par la lumière possèdent une solubilité ou une sensibilité à l'attaque chimique, qui diffère de celle des parties non atteintes par la lumière, caractérisé en ce qu'on forme l'image d'un réseau dans lequel il est prévu un ou plusieurs éléments de réseau par millimètre carré, et qu'on exécute la dissolution ou l'attaque chimique jusqu'à ce que des éléments cylindriques ou des éléments sphériques en saillie deviennent visibles dans la couche photosensible ou dans le support.

2. Procédé pour fabriquer une structure plane active du point de vue optique, selon lequel on imprime un réseau de points ou de lignes constitués en un matériau empêchant ou retardant la dissolution ou l'attaque chimique, sur une plaque ou une feuille transparente constituée en un matériau soluble ou pouvant être attaqué chimiquement, caractérisé en ce qu'on imprime un réseau, dans lequel il est prévu un ou plusieurs éléments du réseau par millimètre carré, et qu'on exécute la dissolution ou l'attaque chimique jusqu'à ce que des éléments cylindriques ou des éléments sphériques en saillie soient visibles dans le matériau empêchant ou retardant la dissolution ou l'attaque chimique, dans la plaque ou dans la feuille.

3. Procédé pour fabriquer une structure plane active du point de vue optique, selon lequel on forme optiquement l'image d'un réseau de points ou de lignes sur une plaque métallique comportant une couche photosensible, dont les parties atteintes par la lumière possèdent une sensibilité à l'attaque chimique qui diffère de celle des parties non atteintes par la lumière, à la suite de quoi on exécute l'attaque chimique, puis on réalise un modelage plastique de la surface de la plaque métallique sur la surface d'une feuille ou d'une plaque transparente, caractérisé en ce qu'on forme l'image d'un réseau, dans lequel il est prévu un ou plusieurs éléments de réseau par millimètre carré, et qu'on exécute l'attaque chimique jusqu'à ce que la surface de la plaque métallique convienne pour le moulage d'éléments cylindriques ou d'éléments sphériques en saillie.

FIG.1

FIG. 3

FIG. 4

FIG.2

FIG.5

FIG.6